(19) Europäisches Patentamt
European Patent Office
Office européen des brevets

(11) **EP 2 320 565 A1**

(12) **EUROPEAN PATENT APPLICATION**

(43) Date of publication:
**11.05.2011 Bulletin 2011/19**

(51) Int Cl.:
*H03K 3/356* $^{(2006.01)}$    *H03K 5/00* $^{(2006.01)}$

(21) Application number: **09252562.5**

(22) Date of filing: **05.11.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(71) Applicant: **NXP B.V.**
**5656 AG Eindhoven (NL)**

(72) Inventors:
• **Meijer, Rinze Ida Mechtilidis Peter**
**Redhill,**
**Surrey, RH1 1DL (GB)**

• **Elvira Villagra, Luis**
**Redhill,**
**Surrey, RH1 1DL (GB)**

(74) Representative: **Ashton, Gareth Mark**
**NXP Semiconductors**
**Intellectual Property and Licensing Department**
**Betchworth House**
**57-65 Station Road**
**Redhill, Surrey RH1 1DL (GB)**

(54) **A delay component**

(57)    A delay component (312) for connecting to a logic component (302, 304), the delay component (312) having an input pin (314), an output pin (316) and a clock pin (318). The delay component (312) is configured to transmit data from the input pin (314) of the delay component to the output pin (316) of the delay component during a first phase of a clock signal received at the clock pin (318) of the delay component; and not to transmit data from the input pin (314) of the delay component to the output pin (316) of the delay component during a second phase of a clock signal received at the clock pin (318) of the delay component.

## Figure 3

**Description**

The present disclosure relates to the field of delay components, in particular, but not exclusively to delay components that are configured to address hold violations in digital circuits.

Traditionally, digital integrated circuits are synchronous in nature. The state of logic components including registers and flip-flops change as a result of a clock signal. Ideally, the states of a group of flip-flops should change simultaneously. The group of flip-flops may be a subset of flip-flops, and multiple clock domains may be provided so that a first group of flip-flops change state at a first time, and a second group of flip-flops change state at a second time. Also, some flip-flops may be excluded from the group in order to save power for example, using clock gating.

In practice however, it is not possible for the states of the group of flip-flops to change simultaneously because of non-idealities in, for example, the clock distribution network for that group of flip-flops. These non-idealities are due to finite delay time of clock buffers, and interconnect propagation delays. In addition, there can be a time delay between the arrival of the clock signal at various flip-flops because the clock distribution network may not be perfectly balanced due to, for example, wire-length differences, process parameter variations, power supply noise, substrate noise, temperature variations, and capacitive coupling. The different clock arrival time at two consecutive flip-flops is generally known as clock skew and can lead to incorrect operation of the circuit.

The listing or discussion of a prior-published document or any background in this specification should not necessarily be taken as an acknowledgement that the document or background is part of the state of the art or is common general knowledge.

According to a first aspect of the invention, there is provided a delay component for connecting to a logic component, the delay component having an input pin, an output pin and a clock pin;
wherein the delay component is configured to:

transmit data from the input pin of the delay component to the output pin of the delay component during a first phase of a clock signal received at the clock pin of the delay component; and
not to transmit data from the input pin of the delay component to the output pin of the delay component during a second phase of a clock signal received at the clock pin of the delay component.

Such a delay component can introduce a delay that is a function of the clock signal received at its clock input, as opposed to a function of the processing performed by the delay component. This can provide advantages in terms of the amount of silicon area/real-estate that is required to implement a delay component that can provide a sufficient delay period to address hold violations in a circuit associated with the delay component. In addition, advantages can be provided in terms of power consumption and current leakage when compared with the prior art. Further still, delay generation can be provided that is independent of the operating conditions and technology used to implement the delay component.

The delay component can be considered as being in a transparent state of operation during the first phase of the clock signal, and in a holding state of operation during the second phase of the clock signal.

The output pin of the delay component may be connectable to an input pin of a logic component and/or the input pin of the delay component may be connectable to an output pin of a logic component.

The delay component may be connectable to a single logic component, for example in order to provide a new component that comprises a logic component and the delay component together.

The delay component may be for connecting to two logic components, in which case, the output pin of the delay component can be connectable to an input pin of a first logic component; and the input pin of the delay component can be connectable to an output pin of a second logic component. The delay component may be considered as being connected to two logic components when it is introduced into a circuit path that has been identified as being susceptible to a hold violation.

The first phase of the clock signal may be a period of time when the clock signal is low and the second phase of the clock signal may be a period of time when the clock signal is high, or vice versa. The clock signal may have a 50% duty cycle, or any other duty cycle that provides a sufficient delay period that can reduce or eliminate hold violations.

According to a further aspect of the invention, there is provided a system comprising:

a logic component having an input pin, an output pin and a clock pin; and
a delay component having an input pin, an output pin and a clock pin;
wherein either:

the output pin of the delay component is connected to the input pin of the logic component; or
the input pin of the delay component is connected to an output pin of the logic component; and
the delay component is configured:

to transmit data from the input pin of the delay component to the output pin of the delay component during a first phase of a clock signal received at the clock pin of the delay component; and

not to transmit data from the input pin of the delay component to the output pin of the delay component during a second phase of a clock signal received at the clock pin of the delay component.

The logic component may be a flip-flop, a logic register, or any other known digital component.

The clock pin of the logic component and the clock pin of the delay component may be configured to receive the same clock signal. In this way, any delays caused by a circuit path between an oscillator and the logic component can be accounted for by using the same clock signal with the delay component. This can reduce the likelihood of hold violations.

The flip-flop can be a D-type flip-flop, a scannable flip-flop, or a D-type scannable flip-flop.

The input pin of the flip-flop may be a data input pin or a test input pin.

The system may be a digital circuit. There may be provided a component in a digital cell library, or an integrated circuit comprising any delay component disclosed herein, or any system disclosed herein.

According to a further aspect of the invention, there is provided a method of operating a delay component, wherein the delay component is for connecting to a logic component and comprises an input pin, an output pin and a clock pin, the method comprising:

transmitting data from the input pin of the delay component to the output pin of the delay component during a first phase of a clock signal received at the clock pin; and

not transmitting data from the input pin of the delay component to the output pin of the delay component during a second phase of a clock signal received at the clock pin.

There may be provided a method of operating a circuit, the circuit comprising:

a logic component having an input pin, an output pin and a clock pin;
a delay component having an input pin, an output pin and a clock pin;
wherein either:

the input pin of the logic component is coupled to the output pin of the delay component; or
the output pin of the logic component is coupled to the input pin of the delay component; and
the method comprising:

transmitting data from the input pin of the delay component to the output pin of the delay component during a first phase of a clock signal received at the clock pin; and
not transmitting data from the input pin of the delay component to the output pin of the delay component during a second phase of a clock signal received at the clock pin.

According to a further aspect of the invention, there is provided a method of designing a circuit comprising:

identifying one or more circuit paths in a circuit that are susceptible to a hold violation; and
introducing any delay component disclosed herein into the identified circuit path.

The step of identifying one or more circuit paths in a circuit that are susceptible to a hold violation may be performed by a commercially available timing analysis tool, which can be sensitive to hold violations.

It will be appreciated that the step of "introducing the delay component" may comprise modifying a circuit diagram/schematic so that any circuit that is physically provisioned from the circuit diagram will include the delay component in the identified circuit path.

Any method disclosed herein may be considered as suitable for execution by a computer program, and may be embodied as computer software.

The method may be repeated until all circuit paths in a circuit diagram have been assessed to identify those that are susceptible to a hold violation, and those that are not.

According to a further aspect of the invention, there is provided a method of designing a circuit comprising:

identifying one or more circuit paths in a circuit that are susceptible to a hold violation, wherein the one or more circuit paths are either to or from a logic component; and
replacing the logic components associated with the one or more circuit paths with any system disclosed herein.

The circuit may be an integrated circuit.

According to a further aspect of the invention, there is provided a method of designing a circuit comprising:

identifying one or more circuit paths that are susceptible to a hold violation; and for each identified circuit path:

comparing a hold violation/skew value for the circuit path with a threshold value; and:

if the hold violation/skew value is greater than the threshold value, then:

introducing a first type of delay component into the identified circuit path, wherein the first type of delay component comprises:

an input pin, an output pin and a clock pin;
wherein the delay component is configured:

to transmit data from the input pin of the delay component to the output pin of the delay component during a first phase of a clock signal received at the clock pin; and
not to transmit data from the input pin of the delay component to the output pin of the delay component during a second phase of a clock signal received at the clock pin; and
if the hold violation/skew value is less than the threshold value, then:

introducing a second type of delay component into the identified current path, wherein the second type of delay component comprises one or more buffers.

In this way, a circuit can be designed that incorporates a delay component according to an embodiment of the invention into some circuit paths that are identified as being susceptible to hold violations, and one or more buffers can be incorporated into other circuit paths that are identified as being susceptible to hold violations. This can enable an efficient circuit to be designed that can benefit from advantages of the delay component where they are considered preferable to one or more buffers.

There may be provided a computer program, which when run on a computer, causes the computer to configure any delay component, system, component, circuit, or integrated circuit disclosed herein, or to perform any method disclosed herein.

The computer program may be a software implementation, and the computer may be considered as any appropriate hardware, including a digital signal processor, a microcontroller, and an implementation in read only memory (ROM), erasable programmable read only memory (EPROM) or electronically erasable programmable read only memory (EEPROM), as non-limiting examples. The software may be an assembly program.

The computer program may be provided on a computer readable medium such as a disc or a memory device, or may be embodied as a transient signal. Such a transient signal may be a network download, including an internet download.

A description is now given, by way of example only, with reference to the accompanying drawings, in which:-

Figure 1 illustrates a prior art digital circuit;
Figure 2 illustrates a timing diagram of the circuit of Figure 1;
Figure 3 illustrates a delay component according to an embodiment of the invention;
Figure 4 illustrates a delay component according to another embodiment of the invention;
Figure 5 illustrates a delay component according to a further embodiment of the invention;
Figure 6 illustrates a timing diagram of the circuit of Figure 5;
Figure 7 illustrates a delay component according to a further still embodiment of the invention; and
Figures 8a to 8c illustrate delay components associated with flip-flops according to an embodiment of the invention.

One or more embodiments described herein relate to a delay component that can address hold violations in a digital circuit and an associated methodology for incorporating the delay component into digital circuit design. The delay component may comprise an input pin, an output pin and a clock pin. The input pin and/or the output pin may be coupled to logic components in the digital circuit. The delay component can transmit data from its input pin to its output pin during a first phase of a clock signal received at its clock pin and not transmit data from its input pin to its output pin during a second phase of the clock signal. The first phase may be considered as a "transparent phase" and the second phase may be considered as a "hold phase". The "hold phase" can be longer than any time delays due to "clock skew" so that any processing of data that is performed by a component before the delay component can be completed before it is passed through the delay component. The circuit delay of the delay component can be proportional to a received clock period.

In this way, the delay component can be used to introduce a delay into the circuit that is dependent on the clock signal, and independent of any processing delay introduced by the delay component itself. This may be different to the prior art where one or more buffers, each introducing a fixed delay by processing a received signal, are incorporated into a circuit path. Advantages associated with the invention can include a delay component for addressing hold violations, wherein the delay component is process, supply voltage, technology and/or temperature independent.

As indicated above, clock skew due to a different clock arrival time at two consecutive flip-flops is known. There exist two types of violations as a result of clock skew: set-up violation and hold violation.

A set-up violation can occur when the receiving flip-flop receives the clock signal earlier than the sending flip-flop, or when data arriving at the receiving flip-flop is not stable when the clock signal is received at the flip-flop, for example. The set-up violation can be addressed by lowering the clock frequency of the circuit.

Hold violation occurs when the previous data is not held for long enough when the receiving flip-flop is clocked. Hold violations typically only occur for short paths in the circuit design. A hold violation can be more serious than a set-up violation, because it cannot be fixed by lowering the clock frequency.

It is known to remove any hold violations by increasing the data path delay between a sending and receiving flip-flop such that the data path delay is greater than the clock skew between the flip-flop's clock inputs. One or more embodiments described herein relate to delay components that address hold violations.

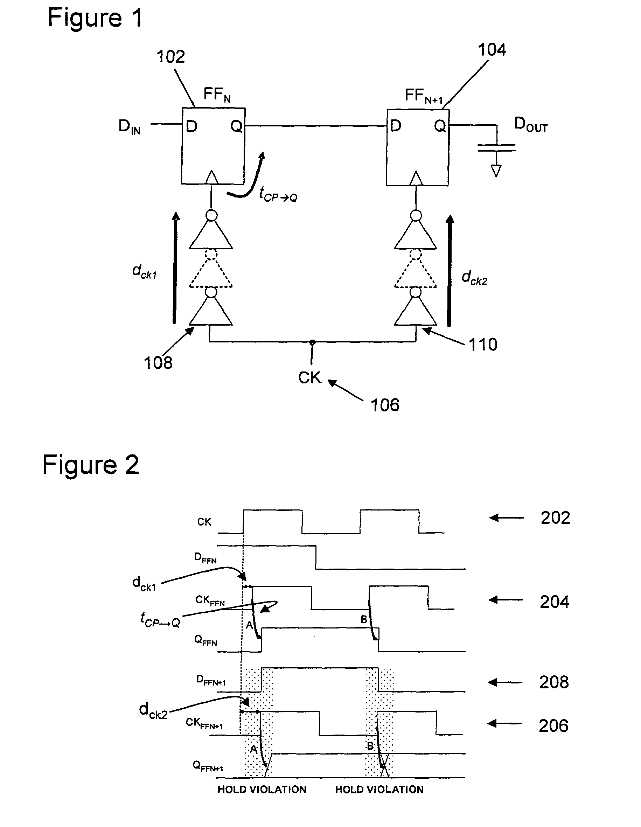

Figure 1 shows a prior art circuit where hold violations are present, and Figure 2 shows signal waveforms for the circuit of Figure 1.

The circuit comprises a first (sending) D-type flip-flop 102 and a second (receiving) D-type flip-flop 104. The Q output of the first flip-flop 102 is connected to the D data input of the second flip flop 104. In this example, one or more inverters 108 are shown between a system clock 106 and the clock pin of the first flip-flop 102 and represent a delay of $d_{ck1}$. Similarly, one or more inverters 110 are shown between the system clock 106 and the clock pin of the second flip-flop 104 and represent a delay of $d_{ck2}$.

It will be appreciated that one or more buffers can be used instead of, or as well as, inverters 108, 110 to build a clock tree and represent a delay.

For the circuit of Figure 1, assume a clock skew where $d_{ck1} < dc_{k2}$ due to a clock network imbalance. This clock skew is assumed to lead to a hold violation.

Signal waveforms for two clock pulses are shown in Figure 2. The flip-flop system clock signal (CK) 202 is delayed by $d_{ck1}$ for the first flip-flop clock signal (CK$_{FFN}$) 204, and delayed by $d_{ck2}$ for the second flip-flop clock signal (CK$_{FFN+1}$) 206. It can be seen that hold violations occur at the second flip-flop because the signal at its D input 208 changes to the new data before the old data is latched.

The following expression needs to be met to avoid hold violations:

$$t_{CP \to Q} + t_{skew} + t_{\log ic} \geq t_{hold} \qquad \forall path \tag{1}$$

Where:

$t_{cp \to Q}$ is the propagation delay of the first (sending) flip-flop,
$t_{skew}$ is the clock skew,
$t_{logic}$ is the total propagation delay of the logic gates in the data path, and
$t_{hold}$ is the hold time requirement of the second (receiving) flip-flop.

A negative value of $t_{skew}$ means that first (sending) flip-flop 102 receives a clock pulse earlier than the second (receiving) flip-flop 104 by a value of $t_{skew}$.

A known solution for eliminating hold violations is to insert combinational delay stages, such as CMOS buffers, into the data path between a first (sending) and second (receiving) flip-flop. This will increase the value of $t_{logic}$ in expression (1) above so that the expression can be satisfied. Disadvantages associated with this approach include:

1. an increase in silicon area for each extra inserted delay stage;
2. an increase in power consumption for each extra inserted delay stage;
3. an increase in leakage current for each extra inserted delay stage;
4. the fact that the inserted delay is proportional to the number of stages inserted, and therefore a large number of stages are needed to realize a large delay value; and

5. the fact that this approach is not technology-scaling friendly. As buffer delays become smaller in next generation technologies, more buffers may need to be inserted to realize a required absolute delay.

Other known solutions for increasing delay of CMOS stages include:

1. using high threshold voltage devices;
2. downscaling transistor widths; and
3. increasing transistor channel lengths.

The prior art may be considered as including sufficient buffers into a circuit path that will prevent hold violations for a worst case scenario, which can include an assumption that that the fastest possible process is being performed at the lowest possible temperature. Embodiments of the invention can avoid/reduce the need to account for a worst case scenario.

One or more embodiments described herein can reduce or eliminate hold violations, or relax hold timing, by using a sequential delay component/element instead of known combinational delay components. The sequential delay component/element can have a connectivity that is incorporated into the circuit design to deal with hold margin concerns.

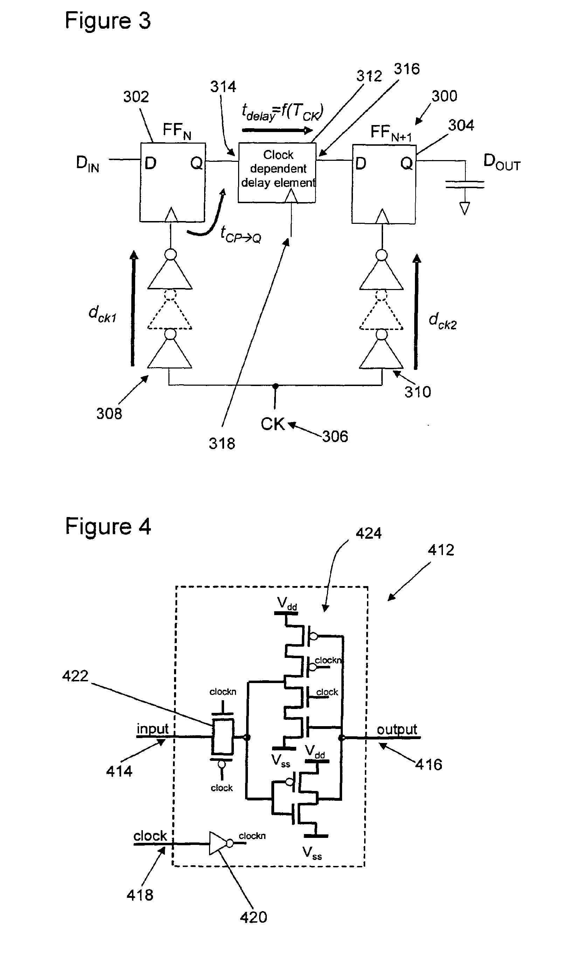

Figure 3 shows an embodiment of a circuit 300 according to an embodiment of the invention. The circuit includes a first (sending) flip-flop 302, a second flip-flop 304 and a delay component 312. The first and second flip-flops 302, 304 are examples of logic components.

The delay component 312, which may be referred to as an HMLatch (hold margin latch), has an input pin 314, an output pin 316 and a clock pin 318. In the example of Figure 3, the input pin 314 of the delay component 312 is connected to the Q output of the first flip-flop 302 and the output pin 316 of the delay component 312 is connected to the D input of the second flip-flop 304. In this way, the delay component 312 is inserted into the circuit/data path between the first and second flip-flops 302, 304 and can provide a time delay ($t_{delay}$) that is a function of the time period of the system clock signal ($f(T_{CK})$).

It will be appreciated that according to some embodiments of the invention, one of the flip-flops 302, 304 may not be required. That is, the delay component 312 may be coupled to an input pin or output pin of a flip-flop for subsequent connection to other electronic components.

The clock pin 318 of the delay component is configured to receive a clock signal that is derived from the system clock 306 as discussed in more detail below.

Processing delays between the system clock 306 and the clock pins of the flip-flops 302, 304 are represented illustratively with inverters 308, 310 in the same way as in Figure 1.

It will be appreciated that in other examples, the circuit path between the system clock 306 and the clock pin of the first flip-flop 302 may not comprise any buffers 308, or the circuit path between the system clock 306 and the clock pin of the second flip-flop 304 may not comprise any buffers 310, and that timing issues such as hold violations can still occur.

In order to remove hold violations, the time delay introduced by the delay component 312 component should be less than one clock period to avoid set-up time violations while having single-clock-cycle communications. The delay component 312 can be implemented by using a negative-edge clocked latch as described in more detail below.

A further feature of embodiments described herein is that the clock pin of the delay component 312 can be connected to either the local clock pin of the first (receiving) flip-flop 302, or the local clock pin of the second (sending) flip-flop 304. This is traditionally not done. Such connection can provide further benefits as the clock signal that is used by the delay component 312 includes at least some of the propagation delay that is experienced by the first or second flip-flop 302, 304 due to the buffers 308, 310. This can mean that the minimum value for the introduced hold time delay (for example $t_{hold}$ in expression (1) above) can be reduced, and therefore that hold violations are less likely.

Specific requirements of an embodiment of the delay component 312 will now be provided with reference to Table 1 below:

| Clock | Previous Input | New input | Output | Mode |
|-------|----------------|-----------|--------|------|
| Low | X | Low | Low | Transparent |
| Low | X | High | High | Transparent |
| High | Low | Low | Low | Hold previous value |
| High | Low | High | Low | Hold previous value |
| High | High | Low | High | Hold previous value |
| High | High | High | High | Hold previous value |

Table 1 illustrates the requirements of the delay component as related to a static level of its clock signal: logic '0' or logic '1'. The signal received at the clock pin 318 of the delay component 312 is provided in Table 1 under the heading "Clock", and can be considered as having two phases: a first phase when the clock signal is low, and a second phase when the clock signal is high. As can be seen from Table 1, the delay component can be considered as being in a transparent mode when the clock is low, and in a hold mode when the clock is high.

In this example, when the delay component 312 is in the transparent mode, the signal at the output pin 316 of the delay component 312 is the same as/follows the signal at its input pin 314. The signal at the output pin is independent of the previous state of the signal at the input pin 314 of the delay component 312. When the delay component 312 is in a hold mode, the signal at the output pin 316 of the delay component 312 does not follow the signal received at its input pin 314, but it keeps the previous state of the signal at the output pin 316. It will be appreciated that the previous state of the signal is that state before the clock signal went high.

Figure 4 illustrates an embodiment of a delay component 412 according to an embodiment of the invention. The delay component 412 has an input pin 414, an output pin 416, and a clock pin 418. The clock pin 418 is coupled to an inverter 420 to make available a signal that is the inverse of the clock signal received at the clock input 418, and the inverse clock signal is given reference "clockn" in Figure 4.

The input pin 414 is coupled to a pass-gate component 422, and the output of the pass-gate 422is connected to a latch 424 that consists of six transistors as shown in Figure 4. The pass-gate 422 passes the input signal 414 to a node of the latch 424, based on the state of the clock signal. When the clock signal = '0' (the low/first phase of the clock), the pass-gate 422 is transparent, and when the clock signal = '1' (the high/second phase of the clock), the pass-gate 422 is <u>not</u> transparent as shown in Table 1 above.

The memory element in the delay component 412 is the latch 424, which holds its state during the high phase of the clock, and is transparent and acts as a buffer during the low-phase of the clock.

It will be appreciated that the circuit diagram of the example delay component 412 that is shown in Figure 4 is one of many ways that the desired functionality of a delay component can be provided. For example, different types, and/or a different number, of transistors can be used whilst still achieving the desired functionality.

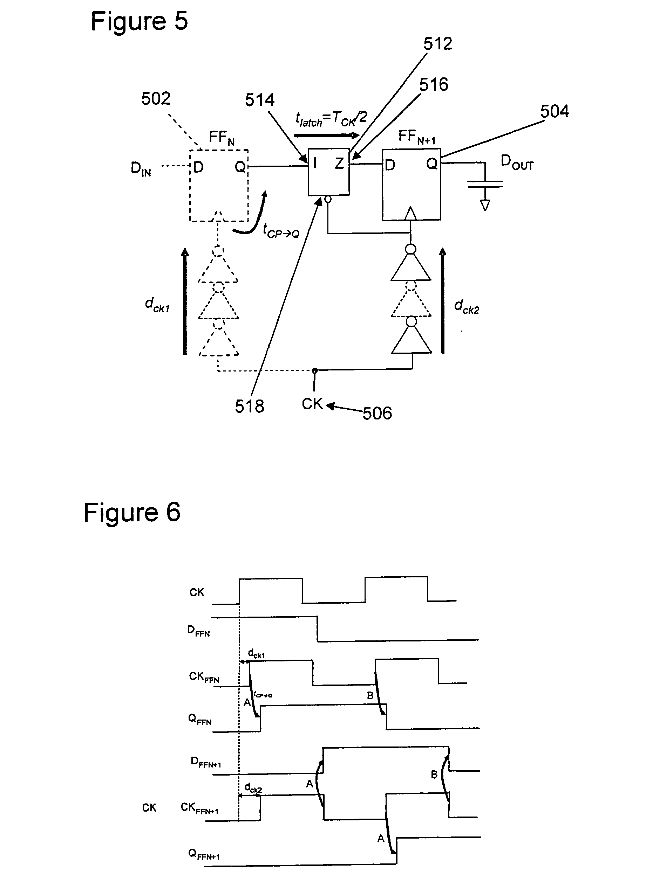

Figure 5 illustrates a circuit according to another embodiment of the invention. The circuit comprises a first logic component 502, a second logic component 504 and a delay component 512. In this example the two logic components 502, 504 are D-type flip-flops, although in other embodiments the logic components 502, 504 can be any digital signal processing signal including any type of flip-flop or register. The delay component 512 is an HMlatch.

In this example, the first flip-flop 502, and its associated circuitry can be considered as optional, and this is why these components are shown with dashed lines in Figure 5. The HMlatch 512, which is a sequential element, or latch function, is provided in between the first and second flip-flops 502, 504 as shown in Figure 5. The output pin of the first flip-flop 502 is coupled to the input pin 1 514 of the HMlatch 512, and the output pin Z 516 of the HMlatch 512 is coupled to the D input pin of the second flip-flop 504. The clock pin 518 of the HMlatch 512 is connected to the clock pin of the second flip-flop 504 so that it receives the same clock signal as the second flip-flop 504.

The purpose of this HMlatch 512 is to introduce a delay to the signal provided by the output of the first flip-flop 502 before it is provided to the input of the second flip-flop 504. The delay in this example starts from a transition on the clock signal received at the HMlatch 512 and the second flip-flop 504 and provides a delay of a half clock period ($T_{cK}$/2). This can reduce or prevent hold violations.

In this example, the HMlatch 512 is a negative edge triggered HMlatch 512. When the signal at the HMlatch clock pin 518 is at logic '1', the HMlatch 512 is operating in hold mode (this means that it maintains the previously latched data when the clock pin was at logic '0'), and this may be considered as a second phase of the clock signal. When the signal at the HMlatch clock pin 518 is at logic '0', the HMlatch 512 is in transparent mode (this means that the latch passes its input data to its output) and this may be considered as a first phase of the clock signal.

Example signal waveforms illustrating operation of the circuit of Figure 5 are shown in Figure 6. It can be seen that data "A" is initially latched in the first flip-flop 502 in a first phase of the clock cycle, while it is latched in the second flip-flop 504 in the following phase of the clock cycle, as desired.

For the proposed solution, hold violations will not occur when the following condition holds:

$$t_{skew} < \delta T_{CK} + t_{I \rightarrow Z} + t_{CP \rightarrow Q} - t_{hold} \; \forall path \qquad (2)$$

Where:

$t_{skew}$=$d_{ck1}$-$d_{ck2}$ for the example circuit,
$\delta T_{CK}$+$t_{I \rightarrow Z}$ , is the latch delay of the delay component,

δ is a parameter that models the clock duty cycle at the second flip-flop side,
$t_{CP \to Q}$ is the period of time taken for the flip-flop to pass a value from its input pin to its output pin after the flip-flop receives a clock signal, and
$t_{hold}$ is the hold time requirement.

For a 50% duty-cycle clock, the latch delay equals $t_{l \to z} + T_{cK}/2$. It has been found that for practical implementations, expression (2) can be satisfied because any optimization that is performed to reduce/minimize clock skew means that $t_{skew}$ is typically much less than $|T_{cK}/2|$. A clock skew of $\delta T_{ck} = T_{cK}/2$ maybe considered as unacceptably large as it degrades the performance of the critical (or slowest) data/circuit paths in a circuit.

It will be appreciated that in some embodiments, as long as a condition such as that illustrated by expressions (1) or (2) above can be satisfied, a clock signal having any duty cycle can be used. The proposed solution can be particularly effective for 50% duty-cycle clock signals. Also, typical duty cycles of known circuits that are in the range of 40% to 60%, 30% to 70%, 20% to 80%, or any other value can still enable the delay component 512 to operate correctly.

The HMlatch 512 can be implemented as a standard digital cell. Its connectivity in the circuit can offer the benefits of relaxed hold timings. It will be appreciated that the delay added by the HMlatch 512 can be determined by the clock frequency only, and not the processing that is performed by the HMlatch 512 itself, or at least any delays caused by the processing of the HMlatch 512 are not predominant. For example, the extra delay that is incorporated by the delay component 512 is generally independent from process, voltage, temperature (PVT) conditions (at least the $\delta T_{cK}$ portion).

In contrast to known buffer insertion, embodiments of the invention can be considered as technology-scaling proof. As the delays of combinational gates generally decrease as technology moves forward, embodiments disclosed herein may not have such technology scaling dependency due the relationship of the delay component with the clock frequency and not the processing speed of a combinational gate. That is, any changes in the delays of combinational gates may not significantly influence the delay that is provided by the delay component.

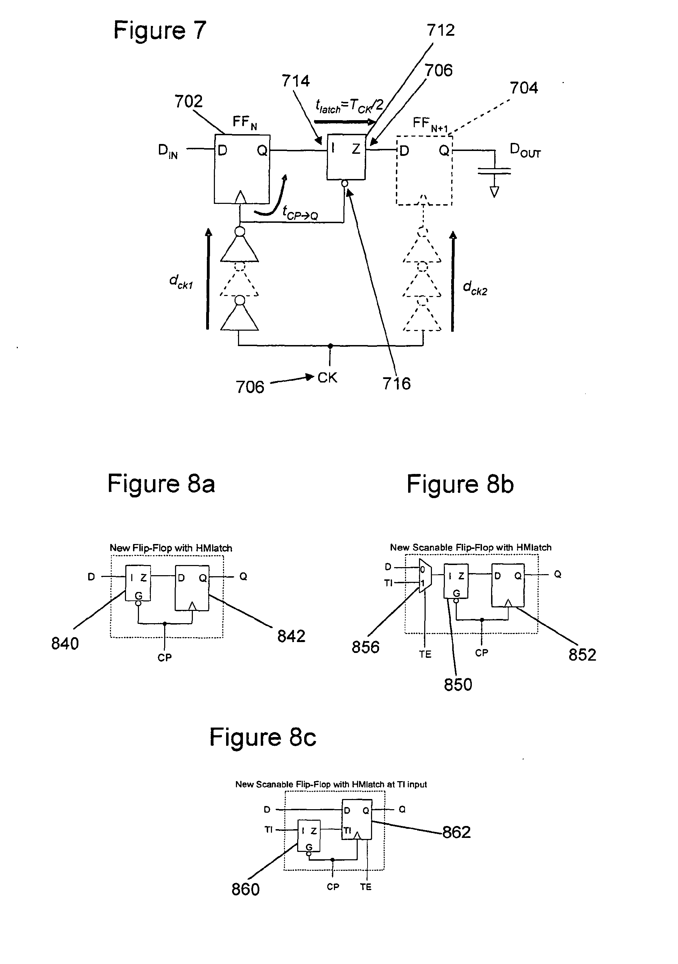

A further embodiment of a circuit according to an embodiment of the invention is illustrated as Figure 7. Components of the circuit of Figure 7 that are similar to components of Figure 5 are given corresponding reference numbers in the 700 series. The difference between the circuit of Figure 7 and the circuit of Figure 5 is that the clock pin 716 of the HMlatch 712 is connected to the clock pin of the first (sending) flip-flop 702 instead of the clock pin of the second (receiving) flip-flop 702. Again, the purpose of the HMlatch is to delay the received signal by half a clock period ($T_{cK}/2$).

It will be appreciated that in this embodiment, the second flip-flop 704 and its associated circuitry may be considered as optional in the same way as the first flip-flop 502 of Figure 5 is considered optional.

In order for the circuit of Figure 7 to operate correctly, the following condition should be satisfied:

$$ t_{skew} < \delta T_{CK} + t_{l \to z} - t_{hold} \qquad \forall path \qquad (3) $$

Where:

$t_{skew} = d_{ck1} - d_{ck2}$ for the example circuit,
$\delta T_{ck} + t_{l \to z}$ is the latch delay of the delay component,
δ is a parameter that models the clock duty cycle at the second flip-flop side, and $t_{hold}$ is the hold time requirement.

By comparing expression (2) with expression (3), it will be appreciated that the embodiment illustrated by Figure 7 is less skew-tolerant than the embodiment illustrated by Figure 5. This is because the value for $t_{skew}$ has to be less than a larger value for expression (2) (the embodiment of Figure 5) that includes a "$t_{CP \to Q}$" value. Nonetheless, the achievable delay by the HMlatch 712 of Figure 7 can still be sufficient in many practical situations. In some embodiments, it may be advantageous to provide a system/component that comprises the delay component coupled to the output of a first flip-flop 702.

An HMlatch as described herein can be integrated into/combined with a conventional flip-flop, thereby creating a new component in the digital cell library. Such integration can allow a more silicon area-efficient solution than providing the HMlatch as a separate component.

Figures 8a to 8c show three example integration combinations of an HMlatch with a flip-flop. It will be appreciated that other combinations are possible, including coupling the HMlatch to an output of the flip-flop.

Figure 8a shows the concept of a combined HMlatch 840 and a normal D-type flip-flop 842. The output pin of the HMlatch 840 is coupled to the "data input" line of the flip-flop 842 to reduce/prevent hold margin issues, as discussed above. This new (combined) flip-flop can be included in the digital standard cell library, and includes a single clock pin (CP) that is coupled to both the HMlatch 840 and the D-type flip-flop 842.

Figure 8b shows another concept where the HMlatch 850 is combined with a scannable flip-flop 852. The scannable flip-flop 852 is represented by its basic components: 1) a multiplexer 856 and 2) a D-flip-flop 852.

The HMlatch 850 is inserted in between the output of the multiplexer 856 and the D input of the flip-flop 852 in order to address hold margin issues on both data path (D), and scan path (TI).

In some examples, hold margin issues may only be associated with the scan path of a scannable flip-flop. Figure 8c shows a possible implementation that integrates an HMlatch 860 into the scanpath of the scannable flip-flop 862. The input pin of the HMlatch 860 is coupled to the test TI input of the combined component and the output pin of the HMlatch 860 is coupled to the test TI input of the scannable flip-flop 862. In this case, hold margin issues associated with the scanpath are addressed, while the data path timing is not disturbed. This can be advantageous in those cases where the data path is timing-critical (related to slowest circuit paths), while hold margin issues occur in the scan path.

In further still examples, any embodiment disclosed herein can be further optimized to have clock disabling/gating of the HMlatch 860 in functional operation mode in order to reduce power overhead. One or more of the embodiments of Figures 8a to 8c, for example, can be compatible with traditional clock gating practices to save power.

It will be appreciated that the embodiments that are illustrated in Figures 8a to 8c are block diagrams, and that the equivalent transistor-level circuit representations may require further optimization as is known in the art to reduce the number of transistors used to implement the proposed functionality.

Embodiments described herein can involve adding additional hardware to a CMOS circuit for fixing hold violations and this can increase the circuit area, power consumption and leakage current in the final design. A prior art solution involves inserting buffers into a circuit path in order to introduce a delay, as discussed before. The disadvantages in terms of area, power, and leakage depend on the number of buffers that are inserted into a given circuit path.

In some cases, a single prior art buffer can be smaller in terms of area, and have lower power and leakage than embodiments of the delay component (HMlatch) described above. That is, embodiments of a delay component described herein may not be better than a single prior art buffer in terms of area, power and/or leakage. However, the penalties in terms of area, power and/or leakage that are associated with introducing several buffers into a given circuit path can be greater than those associated with embodiments of a delay component as described herein. It will therefore be appreciated that in some embodiments there is a threshold number of prior art buffers, below which the prior art buffers can outperform a delay component described herein, and above which a delay component can outperform the prior art buffers.

Taking 65nm CMOS technology as an example, the threshold value in terms of silicon area can be three prior art buffers when compared with the delay component as described in relation to Figure 5. That is, the delay component of Figure 5 is more area efficient than three or more prior art buffers, but not more area efficient than two or less prior art buffers. The delay components described in relation to Figures 8a to 8c can have a threshold value that is less than three buffers.

To quantify the area increment of hold-time violation fixing, a study of the results for a high-performance 45nm CMOS processor design has been performed. The design contains 591 K cells in total including those cells added for fixing hold time violations. The study revealed that about 50K cells are added for fixing hold time violations. For the layout utilization factor used, it was found that the design area is increased by almost 10% when utilizing prior art buffers to address any hold time violations. As a second example, a high-performance 45nm CMOS SoC was analyzed. In this example, a 20% increase of cells was required to provide hold time violation fixing in accordance with the prior art. Both examples demonstrate the relevance of the problem as significant design area is spent in providing hold-time fixing in high-performance designs.

Therefore, a hybrid approach between prior art buffer and HMlatch insertion may be advantageous in some cases and such an approach can comprise an embodiment of the invention. It is observed that the proposed HMlatch solution can be transparent for such an approach.

There will now be provided a description of examples of how to use an HMlatch in the design phase of an integrated circuit (IC) design. For convenience, we will assume that the proposed HMlatch digital cells are available in the digital standard-cell library.

In a first example, the design phase of an IC incorporating the delay component/HMlatch of Figures 5 and 7 is provided by the following pseudocode.

*APPROACH-1*

Step-1: Analyze circuit path timing of the place-and-routed design
Step-2: Identify hold margin violating paths, θ

Step-3:     *if* (number of paths $\theta > 0$) *then{*

            *for* (circuit paths, $\theta$) *do{*

                Insert HMlatch in every circuit path

            }

            Re-execute place-and-route in ECO mode

                (*Hookup HM latch to local clock of receiving flip-flop*)

            Return to Step-1

        }

            *else{*Exit}

As is known in the art, ECO stands for Engineering Change Order, and can involve applying local changes of the place-and-route components rather the re-doing the entire place-and-route.

It will be appreciated that the step of "Identifying hold margin violating paths, $\theta$" may be performed by a commercially available timing analysis tool, which can be sensitive to hold violations.

In a second example, the design phase of an IC incorporating the delay component/HMlatch of Figures 8a to 8c is provided by the following pseudocode.

*APPROACH-2*

Step-1: Analyze circuit path timing of the place-and-routed design
Step-2: Identify hold margin violating paths, $\theta$

Step-3:     *if* (number of paths $\theta > 0$) *then{*

            *for* (circuit paths, $\theta$) *do{*

                Replace receiving flip-flop by new "HMlatch"-based flip-flop in
                every circuit path

            }

            Re-execute place-and-route in ECO mode

                (*Hookup HM latch to local clock of receiving flip-flop*)

            Return to Step-1

        }

            *else{*Exit}

In a third example, an example design method is described that illustrates the hybrid approach of jointly inserting prior art buffers and HMlatches in order to provide hold violation fixing. In such an example, an HMlatch may be referred to as a first type of delay component, and one or more prior art buffers may be referred to as a second type of delay component. As described above, the choice of whether to include prior art buffers or a delay component according to an embodiment of the invention can depend upon the length of the delay that is required in some embodiments.

In the pseudocode that follows, the HMlatch that is used in the one illustrated in Figures 8a to 8c, although it will be appreciated that other embodiments of the HMlatch/delay component can be used with a slight modification of the design method.

In this example, the hold margin requirement is defined as $t_{skew}$, and a clock skew criterion/threshold is defined as $\varpi$, which relates to the maximum clock skew for which prior art buffer insertion is preferable to insertion of the delay component of Figures 8a to 8c. It will be appreciated that the value for $\varpi$ corresponds to the delay that is provided by the threshold value number of prior art buffers. In practice, the value for $\varpi$ may correspond to delay of 1, 2, or 3 prior art buffer delays in a 65nm CMOS technology.

For convenience, $\varpi$ is defined as a negative value because a negative value for $t_{skew}$ is typically used to represent hold margin issues (see expressions (1), (2) and (3) above)

This example design method is denoted as "Approach-3":

*APPROACH-3*

Step-1: Analyze circuit path timing of the place-and-routed design
Step-2: Identify hold margin violating paths, θ

Step-3:     *if* (number of paths *θ > 0*) *then{*

          *for* (circuit paths, *θ*) *do{*

               *if* ($|t_{skew}| \leq |\varpi|$){

                    insert buffer(s) in respective circuit path

               }

               *if* ($|t_{skew}| > |\varpi|$){

                    Replace receiving flip-flop by new "HMlatch"-based flip-flop
                    in every circuit path

               }

          }

          Re-execute place-and-route in ECO mode

               (*Hookup HM latch to local clock of receiving flip-flop*)

          Return to Step-1

     }

     *else*{Exit}

Purely as an example, the value for the clock skew criterion/threshold $\varpi$ may be of the order of 65ps, and the time delay associated with a single buffer may be 50ps. In such an example, the HMlatch may be preferred to prior art buffers when the required clock skew ($t_{skew}$) is more than the delay provided by a single prior art buffer. In typical practical examples, the value for $t_{skew}$ may be of the order of 150ps, and therefore the HMlatch may often be preferred to prior art buffers as the value for $t_{skew}$ is greater than $\varpi$..

In the future, as technology improves, it is expected that the time delay associated with a single buffer may decrease to about 30ps, and it will be appreciated that an appropriate value for $\varpi$ can be selected depending upon specific operational parameters of buffers and/or delay components.

It will be appreciated that one or more embodiments disclosed herein can be applicable to every chip that contains digital logic circuitry.

One or more embodiments described herein can provide a means to limit and/or reduce silicon area overhead when addressing hold time violation fixing in a digital circuit. In fact, embodiments can be applied in any digital circuit design. Embodiments of the delay component disclosed herein can be easily and conveniently used when a tool supported solution is offered, and this can open opportunities for a standardized approach. A "commercial back-end of design tool" or "commercial place-and-route tool" can be enhanced for fixing hold time violation using one or more embodiments disclosed herein.

One or more embodiments disclosed herein can provide:

●Hold violation fixing using clock period knowledge;
● A new flip-flop circuit with hold violation avoidance feature;
● Robust delay generation, that is, independent of process, voltage and temperature variability;
● Technology independent delay generation;
● Fixed clock-cycle based delay generation for guaranteed hold violation fixing;
● Delay generation independent of operating condition settings;
● Reduced penalties for area, power and leakage associated to hold time fixing;
● Modular approach, and in some embodiments a combination with traditional hold violation fixing approaches is possible; and
● One extra circuit component for a path that needs to be fixed.

Embodiments disclosed herein can be relevant for any digital circuit design. In contrast to the prior art, embodiments disclosed herein can be independent of process, voltage and temperature variations. Moreover, embodiments can be technology scaling proof. It is anticipated that embodiments disclosed herein will become even more advantageous as technology evolves, wherein variation in process, voltage, temperature (PVT) are of importance such as in modern 100nm CMOS technologies.

**Claims**

1. A delay component (312) for connecting to a logic component (302, 304), the delay component (312) having an input pin (314), an output pin (316) and a clock pin (318);
   wherein the delay component (312) is configured:

   to transmit data from the input pin (314) of the delay component to the output pin (316) of the delay component during a first phase of a clock signal received at the clock pin (318) of the delay component; and
   not to transmit data from the input pin (314) of the delay component to the output pin (316) of the delay component during a second phase of a clock signal received at the clock pin (318) of the delay component.

2. The delay component (312) of claim 1, wherein either:

   the output pin (316) of the delay component (312) is connectable to an input pin of a logic component (304); and/or
   the input pin (314) of the delay component (312) is connectable to an output pin of a logic component (302).

3. The delay component (312) of claim 1 or claim 2, wherein the first phase of the clock signal is a period of time when the clock signal is low and the second phase of the clock signal is a period of time when the clock signal is high.

4. The delay component (312) of claim 1 or claim 2, wherein the first phase of the clock signal is a period of time when the clock signal is high and the second phase of the clock signal is a period of time when the clock signal is low.

5. A system comprising:

   a logic component (302, 304) having an input pin, an output pin and a clock pin;
   and
   a delay component (312) having an input pin (314), an output pin (316) and a clock pin (318);
   wherein either:

      the output pin (316) of the delay component (312) is connected to the input pin of the logic component (304); or

the input pin (314) of the delay component (312) is connected to an output pin of the logic component (302); and
the delay component (312) is configured:

to transmit data from the input pin (314) of the delay component to the output pin (316) of the delay component during a first phase of a clock signal received at the clock pin (318) of the delay component; and
not to transmit data from the input pin (314) of the delay component to the output pin (316) of the delay component during a second phase of a clock signal received at the clock pin (318) of the delay component.

6. The system of claim 5, wherein the logic component (302, 304) is a flip-flop or a logic register.

7. The system of claim 5 or claim 6, wherein the clock pin of the logic component (302, 304) and the clock pin (318) of the delay component (312) are configured to receive the same clock signal.

8. A component in the digital cell library comprising the delay component (312) of any one of claims 1 to 4, or the system of any one of claims 5 to 7.

9. An integrated circuit comprising the delay component (312) of any one of claims 1 to 4, or the system of any one of claims 5 to 7.

10. A method of operating a delay component (312), wherein the delay component (312) is for connecting to a logic component (302, 304) and comprises an input pin (314), an output pin (316) and a clock pin (318), the method comprising:

transmitting data from the input pin (314) of the delay component to the output pin (316) of the delay component during a first phase of a clock signal received at the clock pin (318); and
not transmitting data from the input pin (314) of the delay component to the output pin (316) of the delay component during a second phase of a clock signal received at the clock pin (318).

11. A method of designing a circuit comprising:

identifying one or more circuit paths in a circuit that are susceptible to a hold violation; and
introducing the delay component of any one of claims 1 to 4 into the identified circuit path.

12. A method of designing a circuit comprising:

identifying one or more circuit paths in a circuit that are susceptible to a hold violation, wherein the one or more circuit paths are either to or from a logic component; and
replacing the logic components associated with the one or more circuit paths with the system of any one of claims 5 to 7.

13. A method of designing a circuit comprising:

identifying one or more circuit paths that are susceptible to a hold violation; and for each identified circuit path:

comparing a skew value for the circuit path with a threshold value; and: if the hold violation/skew value is greater than the threshold value, then:

introducing a first type of delay component (312) into the identified circuit path, wherein the first type of delay component (312) comprises:

an input pin (314), an output pin (316) and a clock pin (318;
wherein the delay component (312) is configured:

to transmit data from the input pin (314) of the delay component to the output pin (316) of the delay component during a first phase of a clock signal received at the clock pin (318); and

not to transmit data from the input pin (314) of the delay component to the output pin (316) of the delay component during a second phase of a clock signal received at the clock pin (318); and if the skew value is less than the threshold value, then:

introducing a second type of delay component into the identified current path, wherein the second type of delay component comprises one or more buffers.

14. A computer program, which when run on a computer, causes the computer to configure the delay component of any one of claims 1 to 4, the system of any of claims 5 to 7, component of claim 8, the integrated circuit of claim 9, or to perform the method of any one of claims 10 to 13.

# Figure 1

# Figure 2

## Figure 3

## Figure 4

# Figure 5

# Figure 6

## Figure 7

## Figure 8a

New Flip-Flop with HMlatch

## Figure 8b

New Scanable Flip-Flop with HMlatch

## Figure 8c

New Scanable Flip-Flop with HMlatch at TI input

Europäisches
Patentamt

European
Patent Office

Office européen
des brevets

**EUROPEAN SEARCH REPORT**

Application Number

EP 09 25 2562

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/058017 A1 (HUMPHREY GUY HARLAN [US]) 27 March 2003 (2003-03-27) * Although claimed to work against alpha particles, the document discloses perfectly the claims; paragraphs [0010] - [0018]; figures 1A,1B,2 * ----- | 1-14 | INV. H03K3/356 ADD. H03K5/00 |
| X | US 2001/015665 A1 (CHOI YOUNG BAE [KR]) 23 August 2001 (2001-08-23) * Shows the latch structure as claimed; paragraphs [0016] - [0019]; figure 3 * ----- | 1-14 | |
| | | | TECHNICAL FIELDS SEARCHED (IPC) H03K |

The present search report has been drawn up for all claims

| Place of search | Date of completion of the search | Examiner |
|---|---|---|
| The Hague | 19 March 2010 | Meulemans, Bart |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

  ...................................................................................

& : member of the same patent family, corresponding
    document

EPO FORM 1503 03.82 (P04C01)

**ANNEX TO THE EUROPEAN SEARCH REPORT
ON EUROPEAN PATENT APPLICATION NO.** EP 09 25 2562

This annex lists the patent family members relating to the patent documents cited in the above-mentioned European search report.
The members are as contained in the European Patent Office EDP file on
The European Patent Office is in no way liable for these particulars which are merely given for the purpose of information.

19-03-2010

| Patent document cited in search report | Publication date | Patent family member(s) | Publication date |
|---|---|---|---|
| US 2003058017 A1 | 27-03-2003 | JP 2003198334 A | 11-07-2003 |
| US 2001015665 A1 | 23-08-2001 | JP 2001185997 A | 06-07-2001 |
| | | KR 20010048986 A | 15-06-2001 |

EPO FORM P0459

For more details about this annex : see Official Journal of the European Patent Office, No. 12/82